(19) Europäisches Patentamt
European Patent Office
Office européen des brevets

(11) EP 4 703 800 A1

(12) EUROPEAN PATENT APPLICATION

(43) Date of publication:
04.03.2026 Bulletin 2026/10

(51) International Patent Classification (IPC):
*G03F 7/20* (2006.01)

(21) Application number: 24197791.7

(52) Cooperative Patent Classification (CPC):
G03F 7/7055

(22) Date of filing: 02.09.2024

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **MYCRONIC AB**
**183 03 Täby (SE)**

(72) Inventors:
• **Pettersson, Henric**
**764 93 Väddö (SE)**
• **Rådahl, Simon**
**184 92 Åkersberga (SE)**
• **Walther, Jonas**
**169 37 Solna (SE)**

(74) Representative: **AWA Sweden AB**
**Matrosgatan 1**
**Box 5117**
**200 71 Malmö (SE)**

(54) **SHUTTER FOR A MICROLITHOGRAPHY DEVICE AND A MICROLITHOGRAPHY DEVICE WITH A SHUTTER**

(57)     A shutter (40) for a microlithography device, comprises a rotatable body (41), rotatable around a rotation axis (44), and a driving unit. The rotatable body has a length (L) along the rotation axis that is longer than a largest width (W). The rotatable body comprises at least a first plane reflective surface (42) with a surface normal directed in a first direction (N) perpendicular to the rotation axis. The first plane reflective surface is offset (O) from the rotation axis. The rotatable body leaves, for at least a part of the length, a free line-of-sight, passing the rotation axis, in a second direction (S) perpendicular to the rotation axis. The driving unit is configured for turning the rotatable body back and forth between a first rotational position and a second rotational position around the rotation axis. A microlithography device having a shutter is also disclosed.

Fig. 2

# Description

## TECHNICAL FIELD

The present technology concerns in general shutter mechanisms and in particular shutter mechanisms for microlithography devices.

## BACKGROUND

In a microlithography device, one or more laser beams are used to illuminate different portions of a light sensitive substrates surface. The laser beams are moved relative the substrate and at the same time, the intensity of the laser beam is modulated in order to give rise to an intensity pattern at the substrate surface. In modern pattern generators, multiple parallel beams are typically used for increasing the printing speed. At some instances during printing, it is required that the laser beam exposure is interrupted. This is typically achieved by an exposure shutter, blocking the light path of the laser beam.

Exposure shutters according to known art are typically based on a rotating shutter blade design. The shutter blades are today typically extended in the radial direction with respect to the rotation. For a wide collection of laser beams, the blade must be long, resulting in increased moment of inertia and reduced rigidity. This will also inevitably lead to longer switching times and increased vibrations during switching. The switching time for the different beams will also differ.

The operation of shutter blade is normally monostable, with mechanical spring return for power-off safety. However, this gives typically asymmetric switching times and causes heat dissipation while maintaining the shutter open.

It is thus a request to improve the shutter mechanism in microlithography devices, in particular in terms of wide beam collection, fast switching time, low mechanical impact, high frequency usage, and low heat dissipation. Preferably, beam deflection towards a beam dump and no need for power off safety is also requested.

## SUMMARY

A general object is therefore to improve the operation of a shutter for microlithography use.

The above object is achieved by methods and devices according to the independent claims. Preferred embodiments are defined in dependent claims.

In general words, in a first aspect, a shutter for a microlithography device, comprises a rotatable body and a driving unit. The rotatable body is rotatable around a rotation axis. The rotatable body has a length along the rotation axis that is longer than a largest width perpendicular to the rotation axis. The rotatable body comprises at least a first plane reflective surface with a surface normal directed in a first direction perpendicular to the rotation axis. The first plane reflective surface is offset from the rotation axis. The rotatable body leaves, for at least a part of the length, a free line-of-sight, passing the rotation axis, in a second direction perpendicular to the rotation axis, different from the first direction. The driving unit is configured for turning the rotatable body back and forth between a first rotational position and a second rotational position around the rotation axis.

In a second aspect, a microlithography device comprises optical devices configured for handling multiple optical beams provided in a common plane and a shutter according to the first aspect. The rotation axis is positioned in the common plane, presenting the free line-of sight for said multiple optical beams when the rotatable body is positioned in the first rotational position. At least the first plane reflective surface is positioned in the optical path of the multiple optical beams when the rotatable body is positioned in the second rotational position.

One advantage with the proposed technology is that it enables very fast shutter opening/closing times, while still creating lower transients at start and stop. Heat generation from the shutter control is reduced and heat from the laser light during closed conditions is controlled to be dumped in suitable locations. Other advantages will be appreciated when reading the detailed description.

## BRIEF DESCRIPTION OF THE DRAWINGS

The invention, together with further objects and advantages thereof, may best be understood by making reference to the following description taken together with the accompanying drawings, in which:

FIG. 1 is a schematic illustration of a microlithography device;
FIG. 2 is an elevational view of a part of an embodiment of a shutter;
FIG. 3A and 3B are schematic views of geometries of an embodiment of a shutter in a first and second rotational position, respectively;
FIG. 4A and 4B are schematic views of geometries of another embodiment of a shutter in a first and second rotational position, respectively;
FIG. 4C and 4D are schematic views of geometries of another embodiment of a shutter in a first and second rotational position, respectively;
FIG. 5 is an elevational view of a part of another embodiment of a shutter;
FIG. 6A and 6B are schematic views of geometries of yet another embodiment of a shutter in a first and second rotational position, respectively;
FIG. 6C and 6D are schematic views of geometries of yet another embodiment of a shutter in a first and second rotational position, respectively;
FIG. 6E and 6F are schematic views of geometries of yet another embodiment of a shutter in a first and second rotational position, respectively; and
FIG. 7 is a schematic illustration of an embodiment of a microlithography device having a shutter.

DETAILED DESCRIPTION

Throughout the drawings, the same reference numbers are used for similar or corresponding elements.

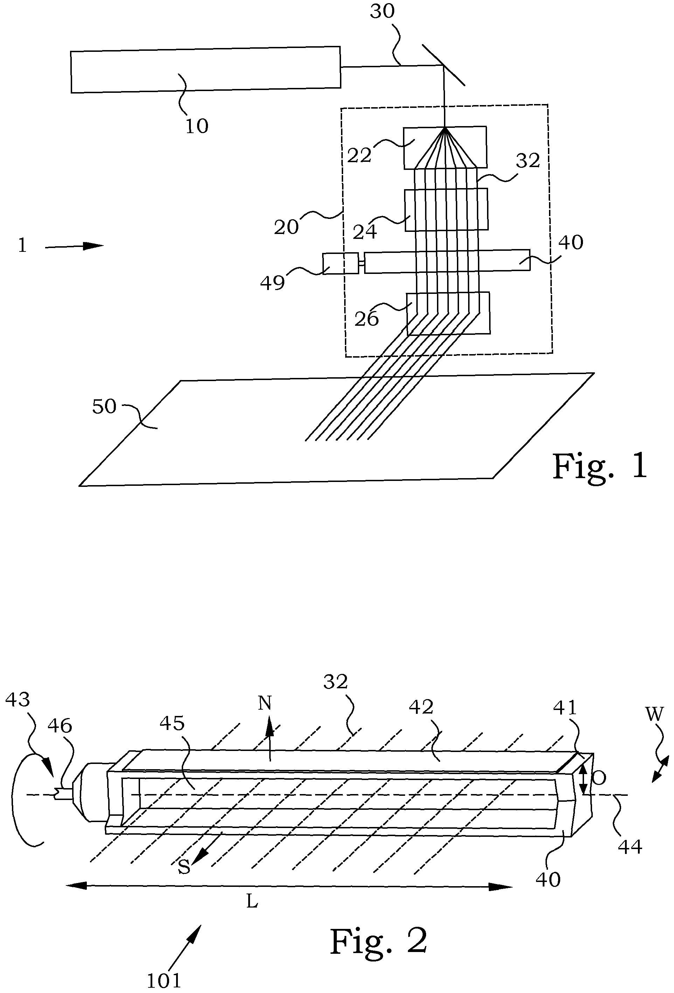

For a better understanding of the proposed technology, it may be useful to begin with a brief schematic overview of a microlithography device. Figure 1 illustrates schematically a microlithography device 1. The microlithography device 1 may e.g. be a mask writer, a direct writer, an inspection device or a pattern measuring device. Typically, a laser source 10 provides a beam of laser light 30. Optical devices, together denoted as 20, are configured for handling multiple optical beams 32 provided in a common plane. The optical beams 32 are brought to and scanned over a substrate surface 50. In case of e.g. writers, the substrate surface 50 is a light sensitive surface that will be modified by the multiple optical beams 32. In case of inspection devices and/or measuring devices, transmitted and/or reflected light emanating from the irradiating laser light is detected.

In a typical design, the laser beam 30 from the laser source 10 is split into a number of optical beams 32 in a beam splitter 32. The different beams of the multiple optical beams are intensity modulated in a modulator 24. A beam scanner 26 scans the multiple optical beams 32 over the surface of the substrate surface 50.

The detailed function of the microlithography device 1 is known, as such, in prior art.

At different occasions it might be requested to shut off the multiple laser beams 32. To this end, a shutter 40 may be provided somewhere in the common plane of the multiple laser beams 32, controlled by the action of a driving unit 49.

There are some problems connected with the prior art shutter designs. As the number of beams may increase further in the future, the length of the exposure shutter has to increase. This in turn increases the moment of inertia and at the same time reduces rigidity. A consequence will be longer switching times and increased vibrations during switching.

The operation of prior art exposure shutters is normally monostable, with mechanical spring return for power-off safety. However, this gives asymmetric switching times and gives rise to heat dissipation while maintaining the shutter open.

For future exposure shutters there are a number of challenges. The shutter should be applicable to multibeam collections with large number of beams. At the same time, faster switching time and low mechanical impact should preferably be provided, and it should allow for high frequency usage. The heat dissipation from the shutter mechanism should be low and preferably, there should be no back reflection or absorption of light when the shutter is shut. Moreover, safety during power-off should be easily handled, i.e. the shutter should maintain its present position even if the power to the shutter control is removed accidentally.

The present solution is basically a combination of a shutter blade or shutter blocker with a very low moment of inertia and a bi-stable solenoid. The moment of inertia, denoted Izz, is typically < 10g*mm². The optical exposure shutter has a shutter aperture blade that has an axial to radial dimension ratio of higher than 1: 1, preferably higher than 5:1 to keep moment of inertia of rotating the shutter aperture blade low.

The light direction is radial to the shutter aperture blade and passes through an aperture opening in open position and is blocked and reflected by the shutter blade in the closed position.

The geometry of the blade is such that it turns around a center axle, but at the same time it can be wide enough to block a wide beam or/and many beams. Addition of further beams only add low Izz to the blade/blocker. This creates lower transients at start and stop because the force needed to accelerate/deaccelerate blade is lower due to the low Izz. The low Izz also makes the shutter opening/closing time very fast due to shorter acceleration and deceleration time without increasing power of actuating solenoid.

The rotational actuator of blade movement is a Bi-stable rotational solenoid which is turning the shutter aperture blade from open to closed. Heat generation from actuating e.g. a bi-stable solenoid is low because the bistable solenoid needs power to change position but not to keep it. It can also be small and have low power usage due to the low Izz blade/blocker.

Figure 2 illustrates schematically shutter 40 for a microlithography device. The shutter 40 comprises a rotatable body 41. The rotatable body 41 is rotatable around a rotation axis 44. The rotatable body 41 has a length L along the rotation axis 44 that is longer than a largest width W perpendicular to the rotation axis 44, preferably considerably longer. Preferably, the rotatable body 41 has a length L along the rotation axis 44 that is at least five times longer than the largest width W perpendicular to the rotation axis 44. The rotatable body 41 serves for disrupting the light path when rotated into a certain position. In other words, the shutter 40 thus has a shutter means that has an axial to radial dimension ratio of higher than 1: 1, and preferably higher than 5:1, to keep the moment of inertia of the rotating shutter means low. The rotatable body 41 comprises at least a first plane reflective surface 42 with a surface normal directed in a first direction N perpendicular to the rotation axis. The first plane reflective surface 42 is offset with a distance O from the rotation axis. Rotation of the rotatable body 41 thereby moves the first plane reflective surface 42 along a circle having the rotational axis 44 in the middle and having a radius equal to the offset distance O.

The rotatable body 41 leaves a free line-of-sight, passing the rotation axis 44 in a second direction S perpendicular to the rotation axis 44. The second direction S is different from the first direction N. This is illustrated in the figure by the dashed lines of the multiple optical beams 32, being able to pass through the rotatable body 41. This free line-of-sight is provided for at least a part of the length L.

A shaft 46 is connected to a driving unit, not shown in this figure. The driving unit is configured for turning the rotatable body 41 back and forth between a first rotational position and a second rotational position around the rotation axis 44. Figure 2 is illustrated when the rotatable body 41 is situated in the first rotational position, in which the free line-of-sight coincides with the plane of the multiple optical beams 32.

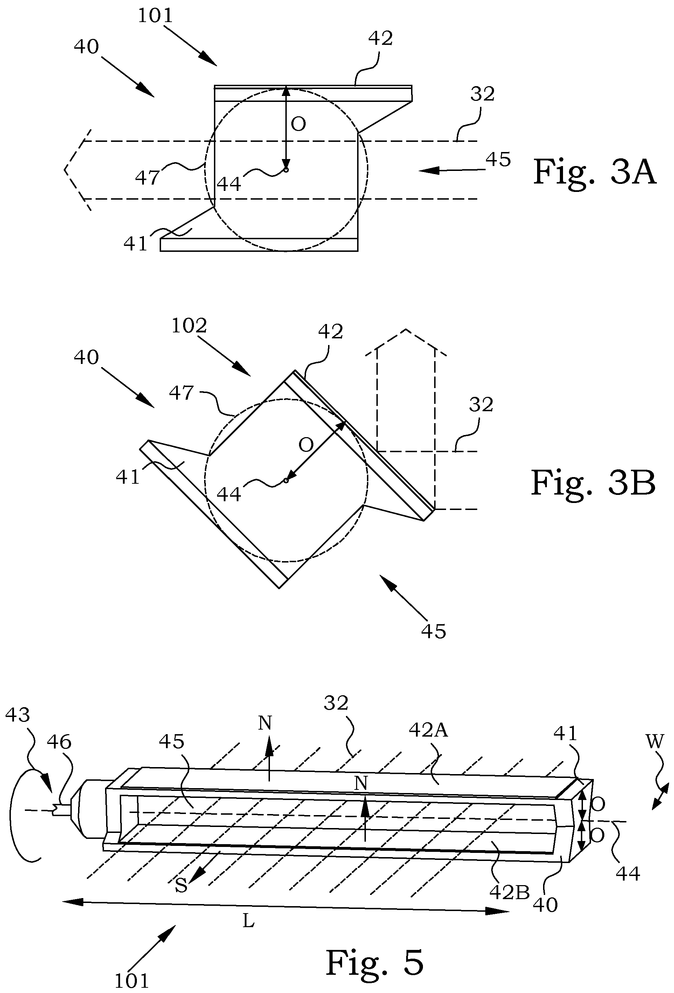

Figure 3A is a cross-sectional view of the rotatable body 41 when situated in the first rotational position 101. The dotted circle 47 indicates a path of a point of the first plane reflective surface 42 being closest to the rotational axis 44. An opening 45 is provided through the rotatable body 41 and the free line-of-sight is directed through this opening 45. This is illustrated by the dashed lines indicating the multiple optical beams 32, which then are allowed to pass through the rotatable body.

Figure 3B is a cross-sectional view of the same rotatable body 41 as in Figure 3A, but when situated in the second rotational position 102. The first plane reflective surface 42 is tilted towards the incoming multiple optical beams 32 and prohibits the multiple optical beams 32 to continue through the rotatable body 41. The multiple optical beams 32 are instead reflected on the first plane reflective surface 42 into another direction. In this direction, a laser dump (not illustrated) may be arranged in order to assimilate the energy. In this particular embodiment, the angle difference between the first and second rotational positions 102 is approximately 45 degrees. However, as will be discussed further below, other angle options may be selected as well.

The solution having a geometry of the first plane reflective surface 42 turning around a center axle and being wide enough to block a multitude of beams and still having a low Izz, creates lower transients at start and stop. This is because the force needed to accelerate/-deaccelerate the first plane reflective surface 42 is low compared to prior art shutters.

The rotation of the rotatable body 41 is performed by the driving unit. In one embodiment, the driving unit is a bi-stable driving unit. This means that the first rotational position and the second rotational position are stable positions. Both positions are maintained even if the driving unit becomes inoperable. Preferably, the driving unit comprises a bi-stable solenoid. Heat generation from actuating Bi stable solenoid is low because the bi stable solenoid needs power to change position but not to keep it.

The low Izz makes the shutter opening/closing time very fast due to shorter acceleration and deceleration time without increasing power of any actuating drive unit, for instance a solenoid. The drive unit can be small and have low power usage due to the low Izz of the rotatable body 41.

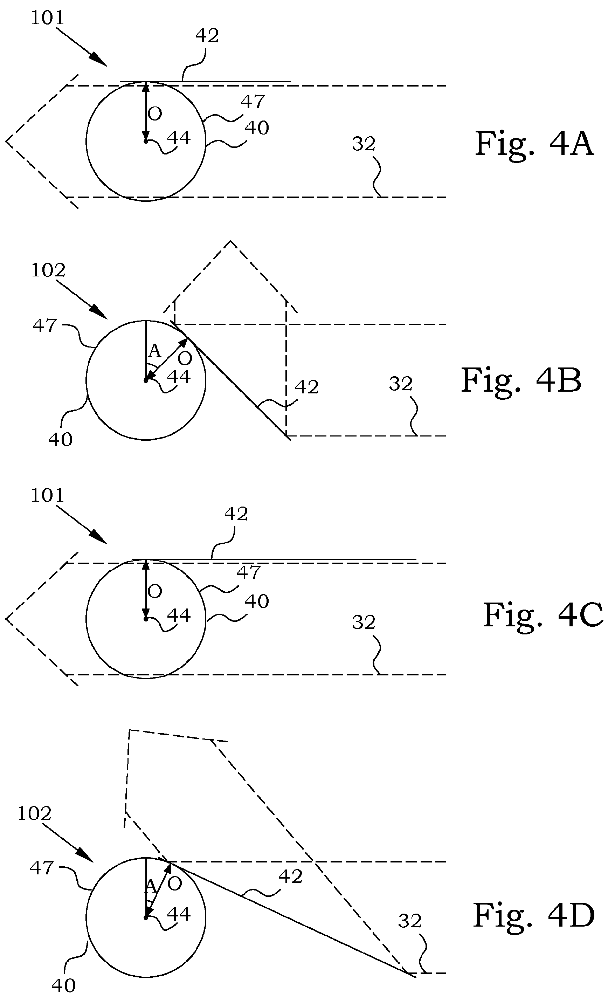

Figure 4A illustrates very schematically the geometries of a rotatable body 41 when situated in the first rotational position 101. The circle 47 indicates a path of a point of the first plane reflective surface 42 being closest to the rotational axis. In this embodiment, the offset O of the first plane reflective surface 42 relative the rotational axis 44 is selected such that the multiple optical beams 32 more or less fills the entire circle 47. The path for the multiple optical beams 32 is anyway free when the first plane reflective surface 42 is placed parallel to the multiple optical beams 32. By reducing the offset O, the moment of inertia of the first plane reflective surface 42 is reduced during rotation around the rotational axis 44.

In Figure 4B, the same embodiment is illustrated, but in the second rotational position 102, rotated and angle A relative to the first rotational position. The first plane reflective surface 42 is long enough to reflect all parts of the multiple optical beams 32. In order to be able to do this, the first plane reflective surface 42 has to extend far beyond the circle 47 in a tangential direction. This will however increase the moment of inertia. The rotation A between the first and second rotational position 102 is relatively limited, however, any reduction in rotation angle would require less energy from the driving unit.

Figure 4C illustrates another embodiment, adapted for a smaller rotational angle, in the first rotational position 101. The first plane reflective surface 42 extends even further outside the circle 47. In Figure 4D, this embodiment is illustrated in the second rotational position 102. A small rotation angle A is used, but the longer extension of the first plane reflective surface 42 will anyway reflect all incoming optical beams 32.

From this, it can be understood that in order to block the same beam width, a reduction in turning angle will give need a wider first plane reflective surface 42, and vice versa. The smallest possible first plane reflective surface 42 used in this way would be for a 90 degrees angle. However, this situation is not very attractive due to the fact that the optical beams then are reflected back into the same optical arrangement from where it, which typically causes problems. An angle somewhat less than 90 is therefore to prefer. A preferred setting of the turning angle and the width of the first plane reflective surface 42 may be a compromise dependent on the actual operation conditions of the driving unit.

Figure 5 illustrates schematically another embodiment of a shutter 40. In this embodiment, the rotational body 41 comprises a first plane reflective surface 42A provided at the outward facing surface of the rotational body 41, as in the previous embodiment. However, in this embodiment, the rotatable body 41 also comprises a second plane reflective surface 42B. The second plane reflective surface 42B has a surface normal directed in the first direction N perpendicular to the rotation axis 44. It is thereby parallel with the first plane reflective surface 42A. The second plane reflective surface 42B is offset O from the rotation axis 44. Thereby, the first and second plane reflective surfaces 42A, 42B both follows circular paths centered around the rotation axis 44.

In this embodiment, the second plane reflective surface 42B is positioned at an opposite side of the rotation axis 44 in relation to the first reflective surface 42A. The free line-of-sight is provided in an opening 45 between the first plane reflective surface 42A and the second plane reflective surface 42B.

The second plane reflective surface 42B is positioned facing towards the rotation axis 44 and the first plane reflective surface 42A is positioned facing out from the rotation axis 44.

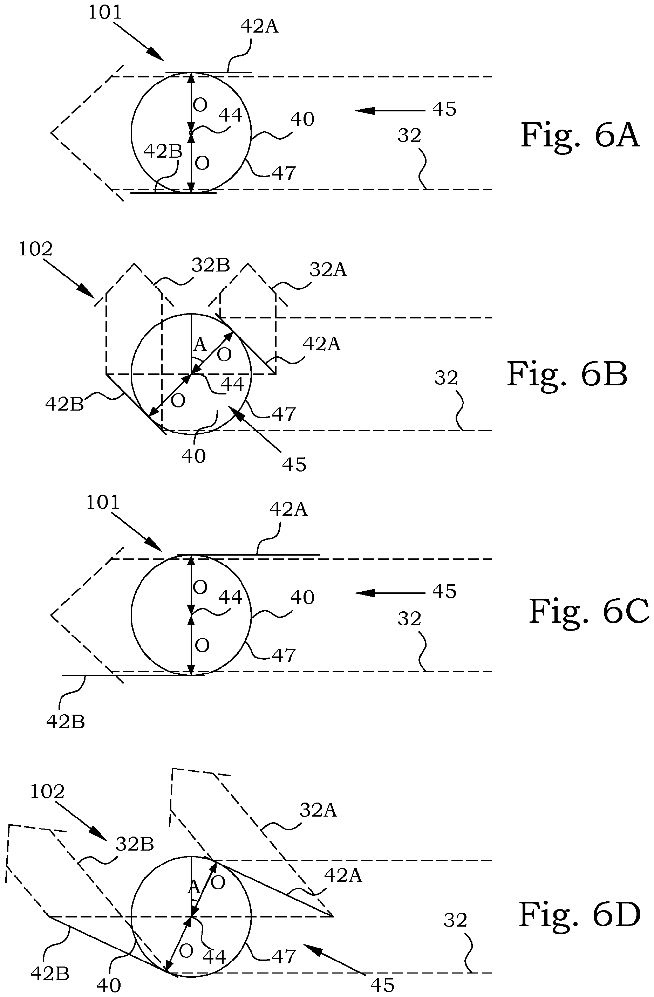

The provision of two plane reflective surfaces 42A, 42B enables a more compact design of the shutter 40. In Figure 6A, some parts, being responsible for the actual shutter functionality, of an embodiment of a shutter 40 is schematically illustrated in a first rotational position 101. The first plane reflective surface 42A is positioned at the top and the second plane reflective surface 42B is placed at the bottom. In this embodiment, the plane reflective surfaces 42A and 42B are somewhat displaced sideways compared to a vertical line through the rotation axis 44. The width of the plane reflective surfaces 42A and 42B are at least times $\sqrt{2}$ the smallest distance between the first reflective surface 42A and the second reflective surface 42B, respectively, and the rotational axis 44. The first plane reflective surface 42A protrudes longer at the right side than at the left side and second plane reflective surface 42B protrudes longer at the left side than at the right side. The optical beams 32 passes through the opening 45.

In Figure 6B, the same shutter is illustrated in the second rotational position 102. The angle A between the first rotational position and the second rotational position 102 in this embodiment is 45 degrees. A first half 32A of the optical beams 32 impinges onto the first plane reflective surface 42A and is reflected away in a direction perpendicular to the original direction. A second half 32B of the optical beams 32 passes the first plane reflective surface 42A but is reflected away by the second plane reflective surface 42B in a direction perpendicular to the original direction. The shutter 40 thus deviates the optical beams 32 in another direction, where a laser dump can be prepared. The rotation of the rotational body is only 45 degrees, and the size of the two plane reflective surfaces 42A, 42B is considerably smaller than for instance the first plane reflective surface in Figure 4A. This reduces the moment of inertia considerably.

In Figure 6C, another embodiment is illustrated in the first rotational position 101. The two plane reflective surfaces 42A, 42B are somewhat longer compared to Figure 6A and therefore present a higher moment of inertia. However, as seen in Figure 6D, by a rotation of the rotational body by an angle A that is much smaller than in Figure 6B, a complete blockage of the optical beams 32 can be achieved. The angle in which the halves 32A, 32B of the optical beams are reflected will also be smaller, since it corresponds to two times the rotation angle A. This embodiment may be advantageous, if a small turning angle is more efficient compared to small moment of inertia.

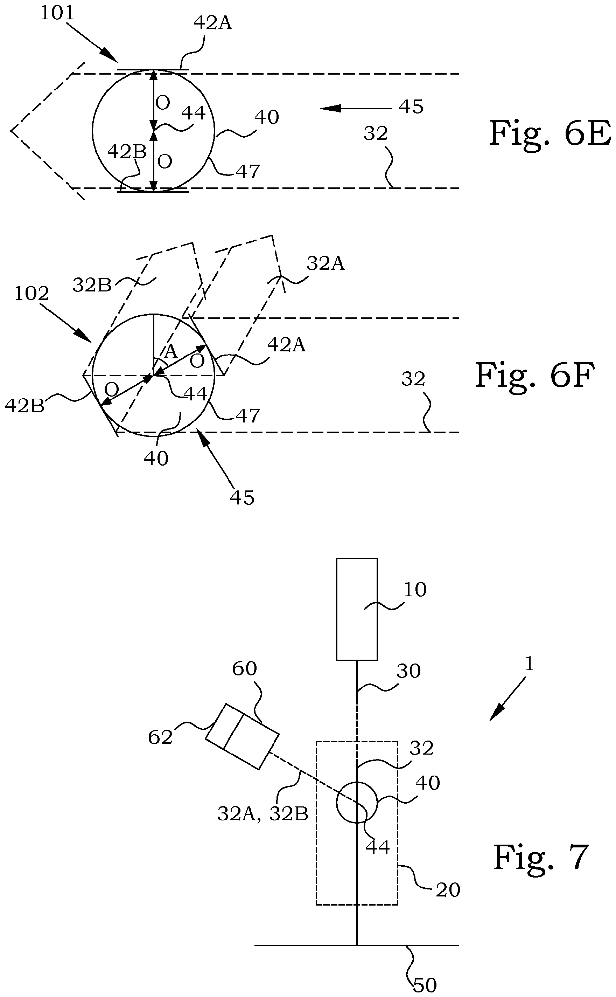

If the opposite situation is present, i.e. that a small moment of inertia is more important than the turning angle between the first and second rotational positions, an embodiment as in Figure 6E may instead be of interest. Here, the two plane reflective surfaces 42A, 42B are small, but at least $2/\sqrt{3}$ times the smallest distance between the first reflective surface 42A and the second reflective surface 42B, respectively, and the rotational axis 44. In this particular embodiment, they are also symmetric around the point being closest to the rotational axis 44. By a 60-degree rotation to the second rotational position 102, as illustrated by Figure 6F, the halves 32A, 32B of the optical beams 32 are reflected to operate as a shutter.

A further rotation of the embodiments having two plane reflective surfaces is not to prefer, since the outgoing beam half 32B then will interfere with the first plane reflective surfaces 42A.

It is thus understood that the compromise between turning angle and the size of the plane reflective surfaces can be adapted to the actual application in question. A too large turning angle may cause problems with physical interaction with the reflected beams. A too small turning angle will result in a small reflection angle, which still may interfere with the remaining optical device. Also the choice between using one or two plane reflective surfaces may be influenced by the actual application.

It is, however, preferred if the first rotational position and the second rotational position differ by a difference angle within the range of 20 to 80 degrees. For a two-plane reflective surfaces design, the difference angle is less than 60 degrees. Most likely, in many embodiment, a difference angle is preferably within the range of 40 to 60.

A two-plane reflective surfaces design, the first reflective surface and the second reflective surface have a width in tangential direction with respect to the rotational axis that is at least equal to least $2/\sqrt{3}$ times a smallest distance between the first reflective surface and the second reflective surface, respectively, and the rotational axis. In applications where a perpendicular reflection of the laser light is requested, the first reflective surface and the second reflective surface preferably have a width in tangential direction with respect to the rotational axis that is at least equal to a smallest distance between the first reflective surface and the second reflective surface, respectively, and the rotational axis, times $\sqrt{2}$.

The solution in the present disclosure is a design for shutting of laser light by reflecting it in another direction where it can be dumped. This is preferably done by having a bi-stable solenoid as actuator for a shutter aperture that is designed with an axial to radial dimension ratio of higher than 1: 1 to keep the moment of inertia rotating around the shutter shaft.

The shutter according to these ideas is preferably used in a microlithography device. However, other applications may also benefit from such a shutter.

Figure 7 illustrates schematically a microlithography device 1. The microlithography device 1 comprises optical devices 20 configured for handling multiple optical beams 32 provided in a common plane. The common plane is in the figure perpendicular to the plane of the paper. The microlithography device 1 further comprises a shutter 40 according to the discussions above. The rotation axis 44 is positioned in the common plane, presenting the free line-of sight for the multiple optical beams 32 when the rotatable body is positioned in the first rotational position. The first plane reflective surface, and when applicable, the second plane reflective surface, is positioned in the optical path of the multiple optical beams 32 when the rotatable body is positioned in the second rotational position. This results in reflected multiple optical beams 32A, 32B, reflected in an angle from the original path of the multiple optical beams 32.

In this embodiment, the microlithography device 1 further comprises a light dump 60 configured to absorb light 32A, 32B reflected by the first plane reflective surface, and if applicable, the second plane reflective surface, when the rotatable body is positioned in the second rotational position.

Furthermore, in this embodiment, the microlithography device further comprises a light sensor 62 configured to measure light 32A, 32B reflected by the first plane reflective surface, and if applicable, the second plane reflective surface, when the rotatable body is positioned in the second rotational position. A reading of the light sensor 62 can then be used as a verification that the multiple optical beams 32 indeed are reflected. This can thus be used as a redundant functionality check of the shutter 40.

The ideas presented above have many advantages. The low moment of inertia of the rotational body enables fast switching times and low mechanical impact on the rest of the arrangement it is applied to. If the rotational body is rotational balanced, which typically is the case at least if two plane reflective surfaces are used, to allow arbitrary orientation and to reduce vibrations and wear. The reflective blocking surface contributes to avoid heat build-up in the shutter itself. By using angled blocking surface, back reflection is avoided. Furthermore, all beams in a multiple beam system are blocked and unblocked at the same time. The shutter is also easy to modify for different width of the beam collection with limited effect on moment of inertia or switching time. Bi-stable operation requires only power during the actual switching, resulting in low power consumption and low heat dissipation.

The embodiments described above are to be understood as a few illustrative examples of the present invention. It will be understood by those skilled in the art that various modifications, combinations and changes may be made to the embodiments without departing from the scope of the present invention. In particular, different part solutions in the different embodiments can be combined in other configurations, where technically possible. The scope of the present invention is, however, defined by the appended claims.

## Claims

1. A shutter (40) for a microlithography device (1), comprising:

   - a rotatable body (41), being rotatable around a rotation axis (44);

     said rotatable body (41) having a length (L) along said rotation axis (44) that is longer than a largest width (W) perpendicular to said rotation axis (44);
     said rotatable body (41) comprising at least a first plane reflective surface (42; 42A, 42B) with a surface normal directed in a first direction (N) perpendicular to said rotation axis (44);
     said first plane reflective surface (42) being offset (O) from said rotation axis (44);
     said rotatable body (41) leaving, for at least a part of said length (L), a free line-of-sight, passing said rotation axis (44), in a second direction (S) perpendicular to said rotation axis (44), different from said first direction (N); and

   - a driving unit (49), configured for turning said rotatable body (41) back and forth between a first rotational position (101) and a second rotational position (102) around said rotation axis (44).

2. The shutter according to claim 1, **characterized in that** said rotatable body (41) having a length (L) along said rotation axis (44) that is at least five times longer than said largest width (W) perpendicular to said rotation axis (44).

3. The shutter according to claim 1 or 2, **characterized in that** said driving unit (49) is a bi-stable driving unit, wherein said first rotational position (101) and said second rotational position (102) are stable positions that are maintained even if said driving unit (49) becomes inoperable.

4. The shutter according to claim 3, **characterized in that** said driving unit (49) comprises a bi-stable solenoid.

**5.** The shutter according to any of the claims 1 to 4, **characterized in that** said rotatable body (41) also comprising a second plane reflective surface (42B) with a surface normal directed in said first direction (N) perpendicular to said rotation axis (44), wherein said second plane reflective surface (42B) being offset from said rotation axis (44).

**6.** The shutter according to claim 5, **characterized in that** said second plane reflective surface (42B) is positioned at an opposite side of said rotation axis (44) in relation to said first reflective surface (42A), whereby said free line-of-sight is provided in an opening (45) between said first plane reflective surface (42A) and said second plane reflective surface (42B) .

**7.** The shutter according to claim 6, **characterized in that** said second plane reflective surface (42B) is positioned facing towards said rotation axis (44) and said first plane reflective surface (42A) is positioned facing out from said rotation axis (44).

**8.** The shutter according to any of the claims 1 to 7, **characterized in that** said first rotational position (101) and said second rotational position (102) differ by a difference angle (A) within the range of 20 to 80 degrees, preferably, less than 60 degrees and also preferably at least 40 degrees.

**9.** The shutter according to any of the claims 1 to 8, **characterized in that** said first reflective surface (42A) and said second reflective surface (42B) have a width in tangential direction with respect to said rotational axis (44) that is at least equal to $2/\sqrt{3}$ times a smallest distance between said first reflective surface (42A) and said second reflective surface (42B(), respectively, and said rotational axis (44).

**10.** The shutter according to claim 9, **characterized in that** said first reflective surface (42A) and said second reflective surface (42B) have a width in tangential direction with respect to said rotational axis (44) that is at least equal to a smallest distance between said first reflective surface (42A) and said second reflective surface (42B), respectively, and said rotational axis (44), times $\sqrt{2}$ .

**11.** A microlithography device (1), comprising:

- optical devices (20) configured for handling multiple optical beams (32) provided in a common plane; and
- a shutter (40) according to any of the claims 1 to 10;

wherein said rotation axis (44) is positioned in said common plane, presenting said free line-of sight for said multiple optical beams (32) when said rotatable body (41) is positioned in said first rotational position (101) and wherein at least said first plane reflective surface (42) is positioned in the optical path of said multiple optical beams (32) when said rotatable body (41) is positioned in said second rotational position (102).

**12.** The microlithography device according to claim 11, **characterized by** further comprising a light sensor (62) configured to measure light reflected by said at least said first plane reflective surface (42, 42A) when said rotatable body (41) is positioned in said second rotational position (102).

**13.** The microlithography device according to claim 11 or 12, **characterized by** further comprising a light dump (60) configured to absorb light reflected by said at least said first plane reflective surface (42, 42A) when said rotatable body (41) is positioned in said second rotational position (102).

Fig. 1

Fig. 2

Fig. 3A

Fig. 3B

Fig. 5

Fig. 4A

Fig. 4B

Fig. 4C

Fig. 4D

Fig. 6A

Fig. 6B

Fig. 6C

Fig. 6D

101

42A

O

44    40    ← 45

42B   O    47    32

Fig. 6E

102

32B    32A

A   O    42A

42B   O

44    47    32

40

45

Fig. 6F

10

60    30

62

32A, 32B    32    40

44

20

Fig. 7

50

1

Europäisches
Patentamt
European
Patent Office
Office européen
des brevets

# EUROPEAN SEARCH REPORT

**Application Number**

EP 24 19 7791

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP H09 266160 A (NIKON CORP) 7 October 1997 (1997-10-07) | 1,2,5,6, 8 | INV. G03F7/20 |
| Y | * the whole document * | 11-13 | |
| A | | 3,4,7,9, 10 | |
| | ----- | | |
| Y | US 2024/248409 A1 (KATO MASAKI [JP] ET AL) 25 July 2024 (2024-07-25) * paragraphs [0057] - [0064]; figure 4 * | 11-13 | |
| | ----- | | |
| A | US 6 744 493 B1 (JOHNSON TERRY A [US] ET AL) 1 June 2004 (2004-06-01) * the whole document * | 1-13 | |
| | ----- | | |
| A | GB 2 178 548 A (ATEQ CORP) 11 February 1987 (1987-02-11) * figures 1-3 * | 1-13 | |
| | ----- | | |

**TECHNICAL FIELDS SEARCHED (IPC)**

G03F

The present search report has been drawn up for all claims

| Place of search | Date of completion of the search | Examiner |
|---|---|---|
| Munich | 14 February 2025 | Roesch, Guillaume |

EPO FORM 1503 03.82 (P04C01)

## ANNEX TO THE EUROPEAN SEARCH REPORT
## ON EUROPEAN PATENT APPLICATION NO.

EP 24 19 7791

This annex lists the patent family members relating to the patent documents cited in the above-mentioned European search report.
The members are as contained in the European Patent Office EDP file on
The European Patent Office is in no way liable for these particulars which are merely given for the purpose of information.

14-02-2025

| Patent document cited in search report | | Publication date | Patent family member(s) | | Publication date |
|---|---|---|---|---|---|
| JP H09266160 | A | 07-10-1997 | NONE | | |
| US 2024248409 | A1 | 25-07-2024 | CN | 117616338 A | 27-02-2024 |
| | | | JP | WO2023282208 A1 | 12-01-2023 |
| | | | KR | 20240012549 A | 29-01-2024 |
| | | | TW | 202309676 A | 01-03-2023 |
| | | | US | 2024248409 A1 | 25-07-2024 |
| | | | WO | 2023282208 A1 | 12-01-2023 |
| US 6744493 | B1 | 01-06-2004 | NONE | | |
| GB 2178548 | A | 11-02-1987 | CA | 1243427 A | 18-10-1988 |
| | | | FR | 2585480 A1 | 30-01-1987 |
| | | | GB | 2178548 A | 11-02-1987 |
| | | | JP | H0658873 B2 | 03-08-1994 |
| | | | JP | S6226819 A | 04-02-1987 |
| | | | JP | H05297318 A | 12-11-1993 |
| | | | KR | 870001045 A | 11-03-1987 |

EPO FORM P0459

For more details about this annex : see Official Journal of the European Patent Office, No. 12/82